Europäisches Patentamt

(19) European Patent Office

Office européen des brevets

(11) Veröffentlichungsnummer: **0 123 133**
A2

## (12) EUROPÄISCHE PATENTANMELDUNG

(21) Anmeldenummer: **84103061.2**

(22) Anmeldetag: **20.03.84**

(51) Int. Cl.³: **H 05 K 5/04**

(30) Priorität: **22.03.83 DE 8308487 U**

(43) Veröffentlichungstag der Anmeldung:
**31.10.84 Patentblatt 84/44**

(84) Benannte Vertragsstaaten:
**AT BE DE FR GB IT NL SE**

(71) Anmelder: **Siemens Aktiengesellschaft**
**Berlin und München Wittelsbacherplatz 2**
**D-8000 München 2(DE)**

(72) Erfinder: **Voigt, Ulrich, Dipl.-Ing.**
**Unertlstrasse 31**
**D-8000 München 40(DE)**

(72) Erfinder: **Hör, Leopold**
**Keplerstrasse 16**
**D-8900 Augsburg(DE)**

(72) Erfinder: **Stöbrich, Werner**
**Albertusstrasse 66**
**D-8901 Biberbach(DE)**

(54) **Abdeckteil für Standgehäuse, insbesondere der Datentechnik.**

(57) Flächig ausgebildetes, an drei seiner Ränder mit Abkantungen versehenes Abdeckteil für Standgehäuse mit Vierkanthohlrohrgerüsten, das an seiner Vorderseite gerundet und am gerundeten Ende mit einer Abkantung versehen ist, an der ein zur Abdeckung hin geöffnetes und mit der Abwinklung nicht bündig abschließendes Winkelstück befestigt ist, wobei zwischen dem nach der Montage zur Gerätewandseite parallel verlaufenden Schenkel des Winkelteils und dem zugehörigen Vierkantholm eine die Schirmung unterstützende Feder angeordnet ist.

FIG 1

EP 0 123 133 A2

0123133

SIEMENS AKTIENGESELLSCHAFT  
Berlin und München

Unser Zeichen  
VPA 83 P 1174 E

## Abdeckteil für Standgehäuse, insbesondere der Datentechnik

Die Erfindung betrifft ein flächig ausgebildetes, an drei seiner Ränder mit Abkantungen versehenes Abdeckteil für Standgehäuse mit Vierkanthohlrohrgerüsten.

In der Datentechnik werden zur Aufnahme der elektrischen Baueinheiten Standgehäuse verwendet, die aus einem Vierkanthohlrohrgerüst bestehen, das rundum mit Abdeckteilen versehen ist, wobei insbesondere die beiden Seitenteile in der Regel spiegelbildlich zueinander ausgebildet sind.

Aufgabe der Erfindung ist es, die seitlichen Abdeckungen von Geräten, insbesondere für die Datenfernverarbeitung mit Verkleidungselementen zu versehen, die die Funktionen wie HF-Schirmung und Verkleidung gleichzeitig übernehmen.

Zur Lösung dieser Aufgabe wird gemäß der Erfindung das Abdeckteil derart ausgebildet, daß seine Vorderseite gerundet und am gerundeten Ende mit einer Abkantung versehen ist, an der ein zur Abrundung hin geöffnetes und mit der Abkantung nicht bündig abschließendes Winkelstück befestigt ist und daß zwischen dem nach der Montage zur Gerätewandseite prallel verlaufenden Schenkel des Winkelteiles und dem zugehörigen Vierkantholm ein zusätzliches Schirmteil angeordnet ist.

Dadurch erhält man ein sehr einfach herzustellendes Seitenteil mit geringen Herstellungskosten.

Dabei ist es vorteilhaft, als Schirmteil eine gewölbte

Zk 1 Fdl/ 9 3. 1983

0123133

Feder zu verwenden.

In weiterer Ausgestaltung kann das Abdeckteil auch derart ausgebildet sein, daß mindestens eine Seite, vorzugsweise die untere Seite im Abstand eines Vierkanthohlrohraußendurchmessers, zweifach abgekantet, mehrfach geschlitzt und nach oben leicht vorgespannt ist. Ein derartig ausgebildetes Seitenteil ist vor allen für höhere Ansprüche bei der HF-Schirmung geeignet.

Anhand der Ausführungsbeispiele nach den Figuren 1 bis 3 wird die Erfindung näher erläutert.

Es zeigen:

Fig. 1 eine perspektivische Darstellung eines Hohlrohrrahmengerüstes, bei dem auf einer Seite das Seitenteil aufgebracht und auf der anderen Seite abgenommen ist,

Fig. 2 einen Schnitt I/I der Fig. 2,

Fig. 3 eine Einzelheit A bei Fig. 1

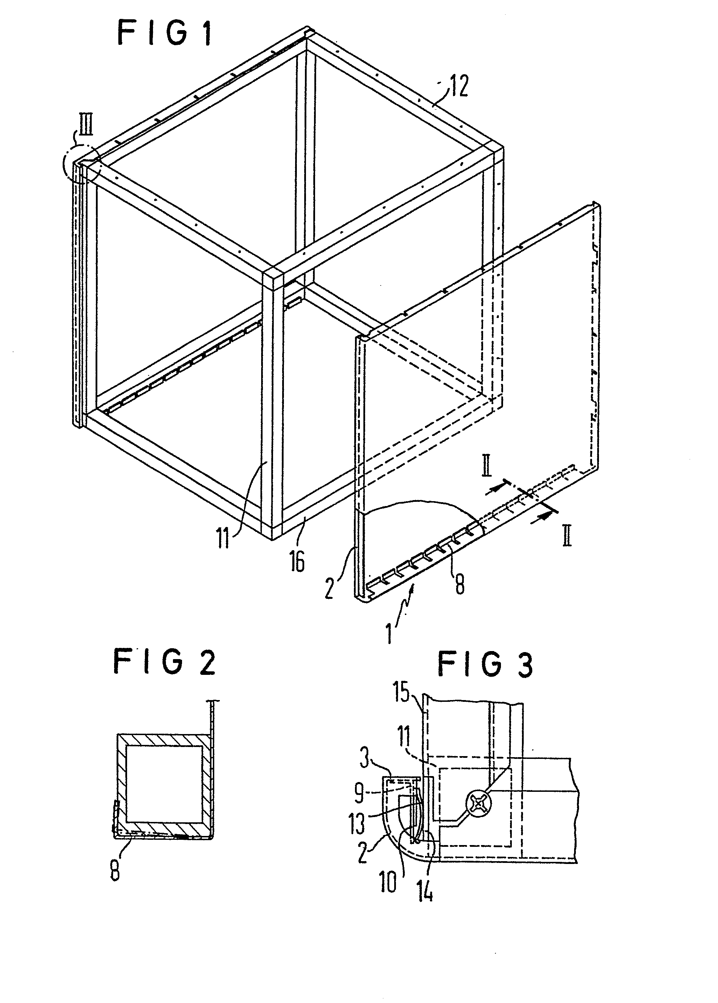

In Fig. 1 ist ein Hohlrohrrahmengerüst, das der Kernbestandteil für ein Standgehäuse ist, wie es für Einrichtungen der Datenverarbeitung verwendet wird, dargestellt. Das Gerüst besteht aus verklebten oder verschraubten Vierkanthohlrohren. An den beiden Kanten sind spiegelbildlich gleiche Abdeckteile 1 angebracht, während die Vorder- und Rückseite mit unterschiedlichen Abdeckteilen versehen ist. Die vorderseitige Abdeckung ist der Einfachheit halber weggelassen. Sie besteht im wesentlichen aus einer Montageplatte und einer darüber befindlichen Abdeckung. Ebenfalls ist die rückseitige Abdeckung nicht gezeichnet.

Das Abdeckteil 1 ist dabei so ausgebildet, daß es an

0123133

VPA 83 P 1174 E

seiner Vorderseite gerundet und nach der Rundung zwei mit einer Abkantung 3 versehen ist. An dieser Abkantung 3 ist der gesamten Vertikallänge nach ein Winkelstück 9 so angebracht, daß es mit seiner geöffneten Seite in Richtung der Abrundung zeigt und außerdem mit der Abkantung nicht ganz bündig abschließt. Zwischen dem Winkelstück 9 und Befestigungslappen 14 der Montageplatte 15, die an dem vertikal verlaufenden Vierkanthohlrohren 11 anliegen, ist eine mit einer konvex verlaufenden Wölbung versehene Feder 13 auf dem einen freien Schenkel 10 des Winkels 9 mit ihrer Flachseite aufgeklebt, so daß sie bei angebrachtem Abdeckteil zwischen dem jeweiligen vertikal verlaufenden Abdeckholm und dem Abdeckteil eingeklemmt ist und so sowohl die mechanische Spannung für das Abdeckteil als auch eine Schirmwirkung erzeugt.

An den übrigen drei Seiten sind die Abdeckteile mit Abkantungen versehen, wobei an der Unterseite des Seiten - teils die Abkantungen im Abstand des Außendurchmessers zweifach ausgeführt ist. Diese Abkantung 8 ist jeweils geschlitzt, so daß eine federnde Wirkung entsteht. Die geschlitzten Teile sind leicht nach oben vorgespannt, wie dies in Fig. 3 dargestellt ist. Diese federnde Abkantung, die nicht nur auf eine Seite beschränkt zu bleiben braucht, bewirkt ein zusätzliches HF-dichtes Abschließen, so daß auch höhere Schirmanforderungen mit dieser Konstruktion erfüllt werden können.

Fig. 2 zeigt in Draufsicht eine Einzelheit A in Fig. 1. Dabei erkennt man die vordere Montageplatte 15 mit den Lappen 14. Zur Montage der seitlichen Abdeckplatte 1 wird die untere Kante federnd eingehängt, das Abdeckteil 1 über die horizintal verlaufenden Holme 16 des Hohlrohrrahmengestelles geschoben und an der oberen und unteren Abkantung angeschraubt. Die Federn 13 zwischen der vorderen Abkantung und dem Hohlrohrrahmengestell dienen neben der HF-Schirmung zugleich dem Toleranzausgleich.

Zur Kompensation der Fertigungstoleranzen können außerdem auch an den Ecken einfache Schirmteile wie elektrisch leitende Schnüre oder Draht eingesetzt werden. Das Gerät muß nicht aus geschlossenen Profilen gefertigt sein, sondern kann auch aus offenen Profilen und auch in selbsttragender Ausführung aus Metall oder Kunststoff bestehen.

3 Patentansprüche
3 FIGUREN

**0123133**

VPA 83 P 1174 E

<u>Patentansprüche</u>

1. Flächig ausgebildetes, an drei seiner Ränder mit Abkantungen versehenes Abdeckteil für Standgehäuse mit Vierkanthohlrohrgerüsten, d a d u r c h   g e k e n n - z e i c h n e t, daß seine Vorderseite (2) gerundet und am gerundeten Ende mit einer Abkantung (3) versehen ist, an der ein zur Abrundung hin geöffnetes und mit der Abkantung (3) nicht bündig abschließendes Winkelstück (9) befestigt ist und daß zwischen dem nach der Montage zur Gerätewandseite parallel verlaufenden Schenkel (1o) des Winkelteiles (9)  und dem zugehörigen Vierkantholm (11) ein zusätzliches Schirmteil (13) angeordnet ist.

2. Flächig ausgebildetes, an drei seiner Ränder mit Abkantungen versehenes Abdeckteil für Standgehäuse nach Anspruch 1, d a d u r c h   g e k e n n z e i c h n e t, daß das zusätzliche Schirmteil (13) eine gewölbte Feder ist.

3. Flächig ausgebildetes, an drei seiner Ränder mit Abkantungen versehenes Abdeckteil für Standgehäuse d a d u r c h   g e k e n n z e i c h n e t, daß mindestens eine Seite vorzugsweise die untere Seite (8) im Abstand des Vierkanthohlrohraußendurchmessers zweifach abgekantet, mehrfach geschlitzt und nach oben leicht vorgespannt ist.

0123133

1/1

F I G 1

F I G 2

F I G 3